# EUROPEAN PATENT SPECIFICATION

(11) **EP 3 309 504 B1**
(45) Date of publication and mention of the grant of the patent: **23.08.2023**
(21) Application number: 17195508.1
(22) Date of filing: 09.10.2017
(51) Int. Cl.: G01B 11/00, G01B 21/04, G01C 11/00, G01S 17/06, G01S 17/66, B25J 19/02, G01C 15/00, G01S 5/16, G06T 7/00, G06F 30/00

(54) **SYSTEM AND METHOD FOR MEASUREMENT BASED QUALITY INSPECTION**
SYSTEM UND VERFAHREN ZUR QUALITÄTSPRÜFUNG AUFGRUND EINER MESSUNGEN
SYSTÈME ET PROCÉDÉ POUR EFFECTUER UN CONTRÔLE QUALITÉ ÉTABLI SUR LA BASE D'UNE MESURE

(30) Priority: 13.10.2016 US 201615292634
(43) Date of publication of application: 18.04.2018
(73) Proprietor: General Electric Company, Schenectady, NY 12345 (US)
(72) Inventor: MURUGAPPAN, Sundar, Niskayuna, NY 12309 (US); RANGARAJAN, Arvind, Niskayuna, NY 12309 (US); BOLINGER, Joseph William, Niskayuna, NY 12309 (US); BALSAMO, Francesco, Niskayuna, NY 12309 (US); BIANCHI, Lorenzo, Niskayuna, NY 12309 (US)
(74) Representative: Novagraaf Group

(56) References cited:
- EP-A1- 2 998 764
- DE-U1-202012 007 557
- US-A1- 2013 253 682
- US-A1- 2015 176 972
- US-A1- 2015 219 451
- US-A1- 2015 345 932
- Leica: "Leica Absolute Tracker AT901 Product Brochure", , 31 January 2010 (2010-01-31), XP055444564, Retrieved from the Internet: URL:http://w3.leica-geosystems.com/downloa ds123/m1/metrology/general/brochures/leica %20absolute%20tracker%20at901%20brochure_u s.pdf [retrieved on 2018-01-25]

## Description

### BACKGROUND

Embodiments of the present invention relate generally to measurement based quality inspection of a component, and more particularly to a system and method for measurement based quality inspection of a component, using an optical tracking and augmented reality technique.

US 2015/176972 A1 discloses a co-ordinate measuring machine having co-ordinate acquisition members including a contact sensitive member, articulation members and a backpack style harness. A position may be measured by referring to the angles of the articulation members and the measured position of a point measured by the co-ordinate acquisition members.

With the advent of computer aided design (CAD) and computer aided manufacturing (CAM), production cycle of manufacturing processes is shortened leading to tremendous gains in productivity. The CAD enabled superior design that resolved many issues associated with manufacturing processes and the CAM increased the efficiency and quality of machined components.

Although the CAD and CAM technologies enhanced design and manufacturing, quality management processes have not changed significantly by technological advancements. Quality inspection of machined parts continued to remain unwieldy, expensive and unreliable. Manual measurement tools, such as calipers and scales provide slower, imprecise, and one-dimensional measurements. Co-ordinate measurement machines (CMM) may be capable of providing a high degree of precision, but are restricted to quality control labs and not generally available on shop floors.

In general, the CMMs measure objects in a space, using three linear scales. Although some devices are available for acquiring radio signal measurements in surgical applications, such devices are not suitable for general purpose industrial applications where three dimensional measurements of parts and assemblies are required.

While computer numerical controlled (CNC) machines could be used in conjunction with robotics to perform measurement of complex components, extensive programing efforts involved render such machines unsuitable for wider deployment in industrial applications.

The present invention is defined in the accompanying claims.

In accordance with one embodiment of the invention, a method according to claim 1 is disclosed. The method includes generating measurement data of a component, using a measurement device coupled to an optical marker device. The method further includes generating co-ordinate data of the measurement device, using the optical marker device and at least one camera. The method includes generating synchronized measurement data based on the measurement data and the co-ordinate data. The method further includes retrieving pre-stored data corresponding to the synchronized measurement data, from a database. The method also includes generating feedback data based on the pre-stored data and the synchronized measurement data, using an augmented reality technique. The method includes operating the measurement device based on the feedback data to perform one or more measurements to be acquired from the component.

In accordance with another embodiment of the invention, a system according to claim 9 is disclosed. The system includes a measurement device coupled to an optical marker device and configured to generate measurement data of a component. The system further includes at least one camera configured to monitor the optical marker device and generate co-ordinate data of the measurement device. The system also includes a measurement control unit communicatively coupled to the measurement device and the at least one camera and configured to receive the measurement data from the measurement device. The measurement control unit is further configured to receive the co-ordinate data from the at least one camera device. The measurement control unit is also configured to generate synchronized measurement data based on the measurement data and the co-ordinate data. The measurement control unit is configured to retrieve pre-stored data corresponding to the synchronized measurement data, from a database. The measurement control unit is further configured to generate feedback data based on the pre-stored data and the synchronized measurement data, using an augmented reality technique. The measurement control unit is also configured to operating the measurement device based on the feedback data to perform one or more measurements to be acquired from the component.

In accordance with another embodiment of the invention, a non-transitory computer readable medium according to claim 12 and having instructions to enable at least one processor module to perform a method for inspection of a component is disclosed. The method includes generating measurement data of a component, using a measurement device coupled to an optical marker device. The method further includes generating co-ordinate data of the measurement device, using the optical marker device and at least one camera. The method includes generating synchronized measurement data based on the measurement data and the co-ordinate data. The method further includes retrieving pre-stored data corresponding to the synchronized measurement data, from a database. The method also includes generating feedback data based on the pre-stored data and the synchronized measurement data, using an augmented reality technique. The method includes operating the measurement device based on the feedback data to perform one or more measurements to be acquired from the component.

### DRAWINGS

These and other features and aspects of embodiments of the present invention will become better understood when the following detailed description is read with reference to the accompanying drawings in which like characters represent like parts throughout the drawings, wherein:
FIG. 1 is a block diagram of a system used for inspection of quality of a component in accordance with an exemplary embodiment;
FIG. 2 is a perspective view of an arrangement of two cameras monitoring a component in accordance with an exemplary embodiment;
FIG. 3 is a perspective view of an optical marker device in accordance with an exemplary embodiment;
FIG. 4 is a flow chart of a method of inspection of quality of a component in accordance with an exemplary embodiment; and
FIG. 5 is a flow chart of a method of inspection of quality of a component in accordance with an exemplary embodiment

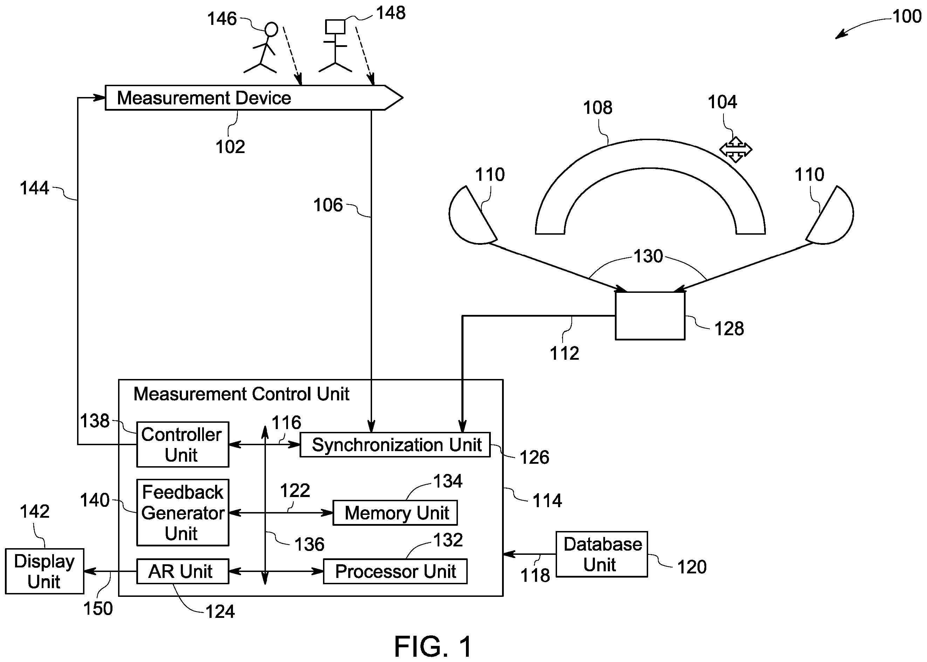

The embodiment shown in figure 1 is not encompassed by the wording of the claims but is considered as useful for understanding the invention.

### DETAILED DESCRIPTION

As will be described in detail hereinafter, a system and a method for measurement based quality inspection of a component are disclosed. More particularly, embodiments of the system and method disclosed herein specifically relate to measurement based quality inspection of a component using an optical tracking and augmented reality technique.

An exemplary technique for performing quality inspection of a component employ a measurement device which is tracked by at least one camera. The measurement device is configured to communicate the measurement data to a measurement control unit. An optical tracking system is configured to track the measurement device, using data provided by the camera, thereby enabling acquisition of measurements in any order. Quality inspection is initiated by calibrating the optical tracking system using an optical tracking device. Specifically, an augmented reality system in co-ordination with the optical tracking system generates a feedback for controlling the measurement device. FIG. 1 is a block diagram of a system 100 used for inspection of quality of a component 108 in accordance with an exemplary embodiment. The system 100 includes a measurement device 102 configured to generate measurement data 106 of the component 108. In one embodiment, the measurement device 102 is operated by an operator. In another embodiment, the measurement device 102 is operated by a robot device. In one specific embodiment, the robot device is configured to operate the measurement device 102 in an automatic mode. In another embodiment, the robot device is configured to operate the measurement device 102 in a semi-automatic mode. In automatic mode, the robot device is pre-programmed to acquire measurements in a sequence without intervention of an operator. In semi-automatic mode, the robot device acquires measurements with occasional intervention from an operator.

The measurement data includes one or more of a length value, a breadth value, a height value, and a radius value. The component may be a complex part specified by hundreds of measurements. In one embodiment, the component is a nozzle of a jet engine. In another embodiment, the component is a fan of a turbine. In the non-claimed illustrated embodiment, the component 108 is coupled to an optical marker device 104. According to the invention, the measurement device 102 is coupled to the optical marker device 104. The optical marker device 104 includes a plurality of optical markers (not labeled in FIG. 1) arranged in a predefined three-dimensional configuration. In one embodiment, the optimal marker device 104 may include four optical markers. In such an embodiment, two optical markers may be disposed on a planar surface and other two optical markers may be in disposed on another planar surface. The optical marker device 104 is used to provide spatial co-ordination and orientation of the component 108 with reference to the measurement device 102 during the quality inspection process.

As discussed herein, the term 'measurement setup' refer to a combination of the component 108 and the optical marker device 104. In an alternate embodiment, where the measurement device 102 is in the vicinity of the component 108, the measurement setup may also refer to a combination of the component 108, the optical marker device 104, and the measurement device 102. The system 100 further includes at least one camera 110 configured to monitor the optical marker device 104. Specifically, the at least one camera 110 is configured to acquire one or more images of the optical marker device 104. The at least one camera 110 is further configured to determine in real-time, a position and an orientation of the optical marker device 104, using a computer vision technique. In the illustrated embodiment, two cameras 110 are used. In other embodiments, the number of cameras 110 may vary depending on the application. A camera synchronization hub 128 is communicatively coupled to the at least one camera 110 and configured to synchronize a plurality of acquired images 130 and generate co-ordinate data 112. The co-ordinate data includes 112 position data having spatial co-ordinates and orientation data having rotational co-ordinates. In some embodiments, the camera synchronization hub 126 is also configured to provide control signals to the at least one camera 110 for changing the orientation and adjusting the focus. The system 100 further includes a measurement control unit 114 communicatively coupled to the measurement device 102 and the at least one camera 110. The measurement control unit 114 is configured to receive the measurement data 106 from the measurement device 102. The measurement control unit 114 is further configured to receive the co-ordinate data 112 from the camera synchronization hub 126 and operate the measurement device 102 to perform one or more measurements of the component 108.

The operation of the measurement device 102 is effected by a control signal 144 generated by the measurement control unit 114.

The measurement control unit 114 includes, an augmented reality (AR) unit 124, a synchronization unit 126, a processor unit 132, a memory unit 134, a controller unit 138, and a feedback generator unit 140 communicatively coupled to each other via a communication bus 136.

Specifically, the synchronization unit 126 is communicatively coupled to the camera synchronization hub 128 and configured to receive the co-ordinate data 112 generated by the camera synchronization hub 128. The synchronization unit 126 is also configured to receive measurement data 106 and generate a synchronized measurement data 116 based on the measurement data 106 and the co-ordinate data 112.

According to the invention, the synchronization unit 126 is configured to modify the measurement data 106 based on the co-ordinate data 112.

The feedback generator unit 140 is communicatively coupled to the synchronization unit 126 and a database 120. The feedback generator unit 140 is configured to receive pre-stored data 118 from the database 120 and the synchronized measurement data 116 from the synchronization unit 126. In one embodiment, the pre-stored data 118 includes predefined measurement data and a plurality of tolerance values corresponding to the predefined measurement data. The term "predefined measurement data" discussed herein includes a plurality of locations of the component 108 where quality inspection measurements are performed. The feedback generator unit 140 is further configured to generate feedback data 122 based on the pre-stored data 118 and the synchronized measurement data 116, using an augmented reality technique.

The augmented reality unit 124 is communicatively coupled to the feedback generator unit 140 and the database 120. In one embodiment, the augmented reality unit 124 is configured to provide live status of progress of measurement by integrating the live measurement data 106 with additional data provided by the feedback generator unit 140. In one embodiment, the augmented reality unit 124 is configured to overlay a live image of a region of inspection of the component 108 with additional data including measurement status information provided by the feedback generator unit 140. In another embodiment, the augmented reality unit 124 is configured to combine visual information of the measurement setup with audio information representative of measurement status information provided by the feedback generator unit 140. In one embodiment, the augmented reality unit 124 may combine one or more of indicators of status of the quality inspection provided by the feedback generator unit 140 with the visual representation of the measurement setup to generate augmented reality information 150. The augmented reality information 150 is transmitted to a display unit 142 for providing visual information regarding the progress of the quality inspection performed by an operator. In one embodiment, when an operator is using the measurement device 102, the augmented reality information 150 is used by an operator 146 to efficiently use the measurement device 102 to perform the quality inspection process. In another embodiment when a robot device 148 is operating the measurement device 102, the augmented reality information 150 is useful for an operator of the robot device to obtain the status of the quality inspection process.

The controller unit 138 is communicatively coupled to the feedback generator unit 140 and configured to generate the control signal 144 for operating the measurement device 102. In one embodiment, the operator receives a signal representative of the feedback data 122 and determines the usage of the measurement device 102 for continuing the quality inspection process. In another embodiment, a robot device may receive the signal representative of the feedback data 122 and generate the control signal 144 to operate the measurement device 102.

The processor unit 132 includes one or more processors. In one embodiment, the processor unit 132 includes at least one arithmetic logic unit, a microprocessor, a general purpose controller, or a processor array to perform the desired computations or run the computer program.

Although the processor unit 132 is shown as a separate unit in the illustrated embodiment, in other embodiments, one or more of the units 126, 138, 140, 124 may include a corresponding processor unit. Alternatively, the measurement control unit 114 may be communicatively coupled to one or more processors that are disposed at a remote location, such as a central server or cloud based server via a communications link such as a computer bus, a wired link, a wireless link, or combinations thereof. In one embodiment, the processor unit 132 may be operatively coupled to the feedback generator unit 140 and configured to generate the signal representative of feedback data 122 for performing quality inspection of the component 108.

The memory unit 134 may be a non-transitory storage medium. For example, the memory unit 134 may be a dynamic random access memory (DRAM) device, a static random access memory (SRAM) device, flash memory or other memory devices. In one embodiment, the memory unit 134 may include a non-volatile memory or similar permanent storage device, media such as a hard disk drive, a floppy disk drive, a compact disc read only memory (CD-ROM) device, a digital versatile disc read only memory (DVD-ROM) device, a digital versatile disc random access memory (DVD-RAM) device, a digital versatile disc rewritable (DVD-RW) device, a flash memory device, or other non-volatile storage devices. A non-transitory computer readable medium may be encoded with a program to instruct the one or more processors to perform quality inspection of the component 108.

Furthermore, at least one of the units 124, 138, 140, 126, 134 may be a standalone hardware component. Other hardware implementations such as field programmable gate arrays (FPGA), application specific integrated circuits (ASIC) or customized chip may be employed for one or more of the units of the measurement control unit 114.

Specifically, the measurement control unit 114 is also configured to generate the feedback data 122 based on the pre-stored data 118 and the synchronized measurement data 116, using an augmented reality technique implemented by augmented reality generation unit 124. In one embodiment, the measurement control unit 114 is configured to overlay a live image of a region of inspection of the component 108 with the one or more measurements to be acquired. In one specific embodiment, the measurement control unit 114 is further configured to verify acquisition of a measurement corresponding to one of the predefined measurement data. In another embodiment, the measurement control unit 114 is further configured to generate at least one of graphical and audio information representative of the feedback data 122. The measurement control unit 114 is further configured to operate the measurement device 102 based on the feedback data 122 to perform one or more measurements to be acquired from the component 108.

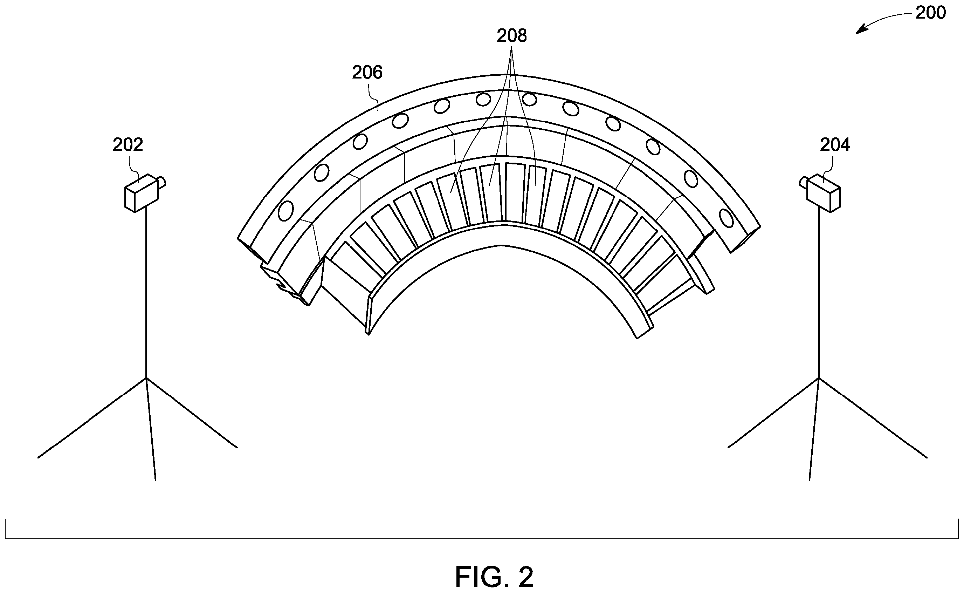

FIG. 2 is a perspective view of an arrangement of two cameras 110 monitoring the component 108 in accordance with an exemplary embodiment. A plurality of measurements to be acquired from a plurality of locations 208 on the component 108 are identified for a specified quality inspection job. In one embodiment, one hundred and eighty measurements of the component 108 are performed for completing a quality inspection process. In another embodiment five hundred measurements of the component part 108 are performed. In such an embodiment, the component 108 may be a nozzle of a jet engine. According to the invention, In the measurement device is digital caliper. The measurement data from the measurement device is electronically transferred to the measurement control unit. In one embodiment, the display of a measurement event may be performed by pressing a button on the measurement device. In another embodiment, the display of a measurement event may be performed by activating a touch screen of the display unit. The exemplary system enables paper-less recording of measurement data, thereby reducing labor and enhancing accuracy of recording of measurements.

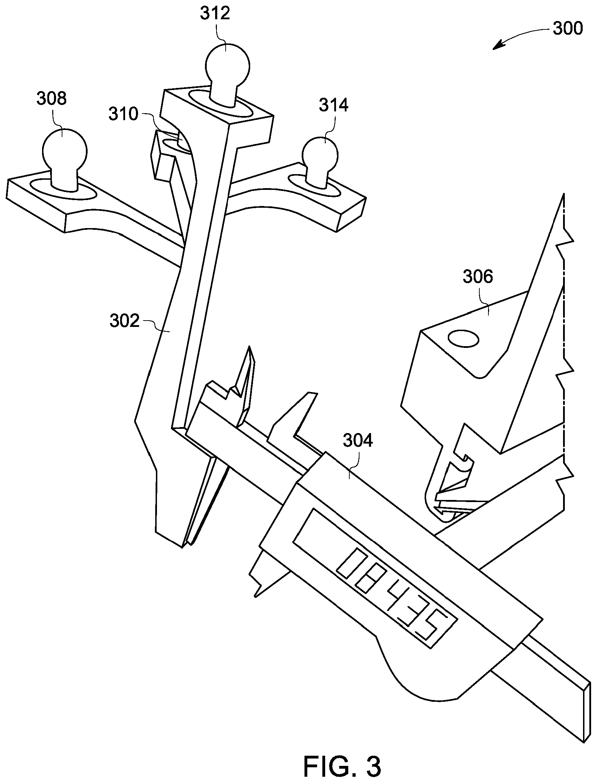

FIG. 3 is an image of an optical marker device 104 in accordance with an exemplary embodiment. The optical marker device 104 has a rigid body attachment 302 which is coupled to the measurement device 102. In one embodiment, the rigid body attachment 302 is manufactured using 3D printing technology. In another embodiment, the rigid body attachment 302 may be manufactured by any other techniques such as molding. The measurement device 102 is disposed at a plurality of predefined locations of the component 108 to acquire a plurality of measurements. In another embodiment, the optical marker device 104 may be coupled to the component 108.

The optical marker device 104 includes a plurality of optical markers 308, 310, 312, 314 positioned at a plurality of points in a three-dimensional space. In one embodiment, the plurality of optical markers 308, 310, 312, 314 may be passive markers that may be identifiable by processing images of the optical marker device 104. In another embodiment, the plurality of optical markers 308, 310, 312, 314 may be active markers such as but not limited to light emitting diodes (LEDs) that emit invisible light, that may be identifiable by detector elements disposed on or near the component 108. A plurality of 3D co-ordinates corresponding to the plurality of markers 308, 310, 312, 314 are used to determine position and orientation of the measurement device. The position and orientation of the measurement device corresponding to a displayed measurement event are used to determine the progress of quality inspection process. The progress of the quality inspection process may be communicated through the display unit to an operator using augmented reality technique.

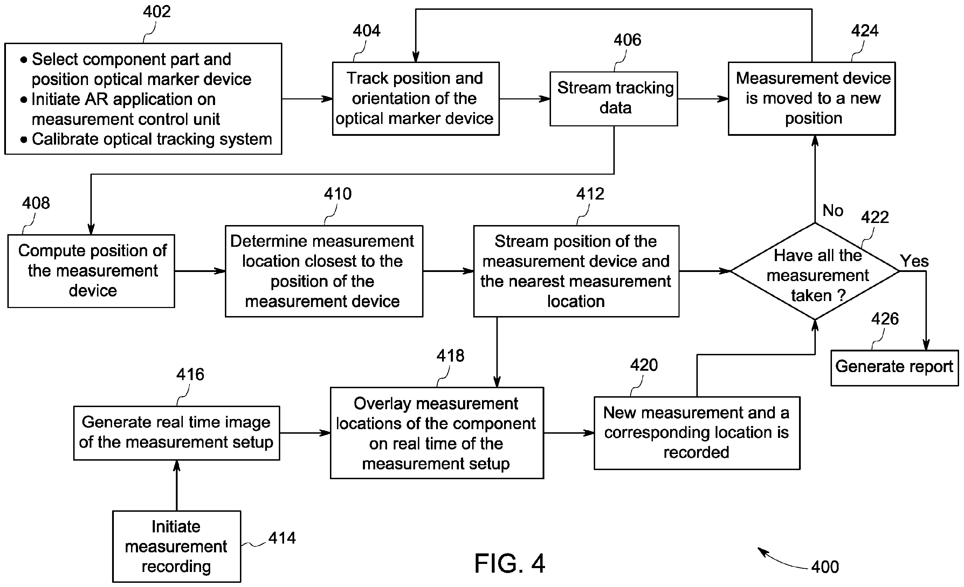

FIG. 4 is a block diagram illustrating a method 400 of quality inspection using optical tracking and augmented reality technique in accordance with an exemplary embodiment. The quality inspection process is initiated by selecting a component and positioning an optical marker device on the component as indicated by step 402. Further, an augmented reality technique is initiated by a measurement control unit. An optical tracking system is calibrated as part of the initialization procedure. The initiation of quality inspection process may include other steps, for example, initiating recording of measurements and generating a real time image of the measurement setup.

Position and orientation of the optical marker device is tracked in real time as indicated in step 404. In one embodiment, the tracking is performed based on the generated video frames. If the rate of video frames generated by the optical tracking system is higher, the tracking may be performed once for several frames. The tracking data is streamed to the measurement control unit as indicated by step 406. The streaming of tracking data to the measurement control unit may be performed using a wired or a wireless connection. The tracking data is used by the measurement control unit to determine the position of the measurement device as indicated by the step 408. In one embodiment, a synchronization unit of the measurement unit is configured to determine the position of the measurement device. In another embodiment, a feedback generator unit of the measurement control unit is configured to determine the position of the measurement device.

A plurality of measurement locations of the component is retrieved from a database during initiation of the quality inspection process. A measurement location proximate to a position of the measurement device is determined as indicated by step 410 based on the position of the measurement device computed in step 408 and the position and orientation of the optical marker device obtained by optical tracking in step 404. The position of the measurement device and the measurement location proximate to the measurement device may be superimposed on a real time image of the measurement setup. In another embodiment, the plurality of measurement locations may be categorized into two groups based on previously acquired measurements. At the beginning of the quality inspection process, all the measurement locations are included in a first group. As the quality inspection process progresses, locations corresponding to the acquired measurements are removed from the first group and included in the second group. The first group and the second group of measurement locations are used for generating a plurality of augmented reality images.

At step 414, recording of measurements of the component is initiated. A real time image of the measurement setup is generated and displayed on a display unit as indicated in step 416. At step 418, all measurement locations of the component are overlaid on the real time image of the measurement setup. In one embodiment, the plurality of measurement locations of first group may be annotated and displayed using a specific color. The plurality of measurement locations of the second group may be annotated differently and displayed using another specific color. Such a display of measurement locations enables the operator to identify the pending measurements and position the measurement device at the remaining locations. In a further embodiment, the location of the measurement device and a measurement location proximate to the measurement device are also overlaid on the real time image, thereby enabling the operator to record a new measurement and corresponding location with higher confidence.

When the measurement device is in a close proximity of a measurement location, the operator proceeds to confirm the recording of the measurement. In one embodiment, the confirmation of the recording of the measurement is indicated by pressing a button on the measurement device. In another embodiment, the confirmation of the recording of the measurement is performed via a touch screen of the display unit. The recorded measurements are transferred via a wireless channel from the measurement device to the measurement control unit.

After all the measurements are obtained, quality inspection reports are generated as indicated in step 426. In certain embodiments where an operator is operating the measurement device, the augmented reality information displayed in the display unit, is used to select a location of new measurement. In certain other embodiments where a robot device is used to operate the measurement device, a suitable location among remaining plurality of locations is selected automatically.

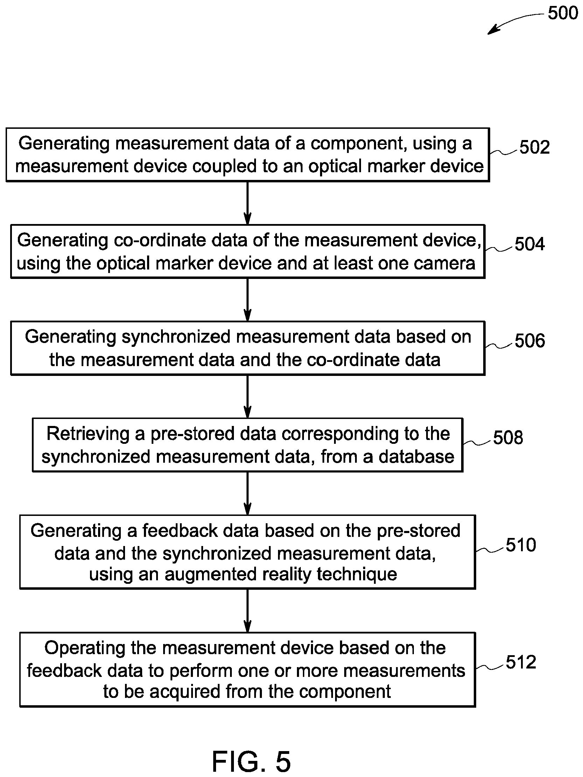

FIG. 5 is a flow chart of a method 500 of inspection of a component in accordance with another exemplary embodiment. The method 500 includes generating measurement data of a component, using a measurement device coupled to an optical marker device as indicated in step 502. In one embodiment, the optical marker device includes a plurality of optical markers arranged in a predefined three-dimensional configuration. In one embodiment, the step of generating measurement data includes initial calibration of an optical tracking system and initialization with predefined measurement data. In one embodiment, the calibration of the optical tracking system includes positioning the component at a convenient position and then positioning the measurement device at an initial measurement location. The calibration of the optical tracking system is concluded after recording of the initial measurement. Subsequently, for other measurement locations, calibration and initialization steps are not required. The generation of measurement data may be performed by selecting measurement locations in any order.

At step 504, the method 500 includes generating co-ordinate data of the measurement device, using the optical marker device and at least one camera. The co-ordinate data includes position data and orientation data. The co-ordinate data is generated by acquiring one or more images of the optical marker device, using the at least one camera. Further a position and an orientation of the optical marker device are determined in real time, using a computer vision technique. Specifically, the step of generating co-ordinate data includes obtaining three dimensional co-ordinates of a plurality of optical markers of the optical marker device, arranged in a predefined three-dimensional configuration. At step 506, the method 500 includes generating synchronized measurement data based on the measurement data and the orientation data. The method of generating the synchronized measurement data includes modifying the measurement data based on the orientation data. At step 508, the method includes retrieving pre-stored data corresponding to the synchronized measurement data, from a database. The pre-stored data includes predefined measurement data and a plurality of tolerance values corresponding to the predefined measurement data. At step 510, the method 500 includes generating feedback data based on the pre-stored data and the synchronized measurement data, using an augmented reality technique. In one embodiment, the feedback data may be representative of a plurality of measurement locations annotated to display progress of inspection. For example, one set of measurement locations may be represented as green dots to indicate completion of measurements and another set of measurement locations may be represented as red dots to indicate pending measurements.

The step of generating the feedback data includes verifying measurement data with the predefined measurement data. The verifying step further includes identifying one or more measurements to be acquired by the measurement device. In one embodiment, generating the feedback data includes generating at least one of graphical and audio information representative of the feedback data. The step of generating the feedback data includes overlaying a live image of a region of inspection of the component with the one or more measurements to be acquired. At step 512, the method includes operating the measurement device based on the feedback data to perform one or more measurements to be acquired from the component. The operating of the measurement device may be performed manually by an operator or automatically by a robot device. In one embodiment, the operation of the measurement device includes repeating the step 502 at a new measurement location.

At the end of the measurement, the operating the measurement device may further include automatic generation of inspection reports. In one embodiment, one of the inspection reports may be a record of measurement data for reviewing purposes. Further, one of the inspection reports may be quality check report generated based on the measurement data. In one embodiment, the inspection reports may be stored in a repository or made available to quality management purposes. In another embodiment, the inspection reports may be processed further without manual intervention to initiate further actions by one or more of research, design, manufacturing and quality departments.

The embodiments discussed herein employ an optical tracking system to obtain position and orientation of a measurement device in relation to a component and an augmented reality image representative of progress of a quality inspection process is generated.

The quality inspection of complex shaped components requiring hundreds of measurements may be performed in relatively shorter time. As a result, an error free recording of measurement data is ensured. Measurements of the component may be obtained in any order. An operator is not burdened with a tedious task of maintaining a record of measurement locations where measurements are to be acquired during the progress of quality inspection of the component.

It is to be understood that not necessarily all such objects or advantages described above may be achieved in accordance with any particular embodiment. Thus, for example, those skilled in the art will recognize that the systems and techniques described herein may be embodied or carried out in a manner that achieves or improves one advantage or group of advantages as taught herein without necessarily achieving other objects or advantages as may be taught or suggested herein. While the technology has been described in detail in connection with only a limited number of embodiments, it should be readily understood that the specification is not limited to such disclosed embodiments. Additionally, while various embodiments of the technology have been described, it is to be understood that aspects of the specification may include only some of the described embodiments. Accordingly, the specification is not to be seen as limited by the foregoing description, but is only limited by the scope of the appended claims.

## Claims

1. A method comprising:
generating (502) measurement data of a component, using a measurement device (102) coupled to an optical marker device (104);
generating (504) co-ordinate data of the measurement device (102), using the optical marker device (104) and at least one camera (110);
generating (506) synchronized measurement data by modifying the measurement data based on the co-ordinate data;
retrieving (508) pre-stored data corresponding to the synchronized measurement data, from a database (120);
generating (510) feedback data based on the pre-stored data and the synchronized measurement data, using an augmented reality technique; and
operating (512) the measurement device (102) based on the feedback data to perform one or more measurements to be acquired from the component;
wherein generating the co-ordinate data of the measurement device (102) comprises:
acquiring one or more images of the optical marker device (104) using the at least one camera (110); and
determining in real-time, a position and an orientation of the optical marker device (104), using a computer vision technique; and
**characterised in that** the measurement data is generated using a digital caliper as the measurement device (102) and includes one or more of a length value, a breadth value, a height value and a radius value of the component.

2. The method of claim 1, further comprising operating the measurement device (102) using a robot device (148).

3. The method of claim 1 or claim 2, wherein generating the co-ordinate data comprises obtaining three dimensional co-ordinates of a plurality of optical markers of the optical marker device (104), arranged in a predefined three-dimensional configuration.

4. The method of any preceding claim, wherein the pre-stored data comprises predefined measurement data and a plurality of tolerance values corresponding to the predefined measurement data.

5. The method of any preceding claim, wherein generating the feedback data comprises verifying acquisition of one or more measurements of the predefined measurement data.

6. The method of any preceding claim, wherein verifying acquisition of the predefined measurement data comprises identifying the one or more measurements to be acquired by the measurement device.

7. The method of any preceding claim, wherein generating the feedback data comprises generating at least one of graphical and audio information representative of the feedback data.

8. The method of any preceding claim, wherein generating the feedback data comprises overlaying a live image of a region of inspection of the component with the one or more measurements to be acquired.

9. A system (100) comprising:
a measurement device (102) to be coupled to an optical marker device (104) of the system and configured to generate measurement data of a component;
at least one camera (110) configured to monitor the optical marker device (104) and generate co-ordinate data of the measurement device (102);
a measurement control unit (114) communicatively coupled to the measurement device (102) and the at least one camera (110) and configured to:
receive the measurement data from the measurement device (102);
receive the co-ordinate data from the at least one camera (110);
modify the measurement data based on the co-ordinate data to generate synchronized measurement data;
retrieve pre-stored data corresponding to the synchronized measurement data, from a database (120) of the system;
generate feedback data based on the pre-stored data and the synchronized measurement data, using an augmented reality technique; and
generate a control signal (144) for operating the measurement device (102) based on the feedback data to perform one or more measurements to be acquired from the component;
wherein the at least one camera (110) is configured to:
acquire one or more images of the optical marker device (104); and determine in real-time, a position and an orientation of the optical marker device (104), using a computer vision technique; and
wherein the measurement data includes one or more of a length value, a breadth value, a height value and a radius value of the component;
**characterised in that** the measurement device (102) is a digital caliper.

10. The system of claim 9, further comprising a robot device (148) configured to operate the measurement device (102).

11. The system of claim 9 or claim 10, wherein the optical marker device (104) comprises a plurality of optical markers arranged in a predefined three-dimensional configuration.

12. A non-transitory computer readable medium having instructions to enable at least one processor module to perform a method comprising:
generating measurement data of a component using a measurement device (102) coupled to an optical marker device (104);
generating co-ordinate data of the measurement device (102), using the optical marker device (104) and at least one camera (110);
generating synchronized measurement data by modifying the measurement data based on the co-ordinate data;
retrieving pre-stored data corresponding to the synchronized measurement data, from a database (120);
generating feedback data based on the pre-stored data and the synchronized measurement data, using an augmented reality technique; and
generating a control signal (144) for operating the measurement device (102) based on the feedback data to perform one or more measurements to be acquired from the component;
wherein generating the co-ordinate data of the measurement device (102) comprises:
acquiring one or more images of the optical marker device (104) using the at least one camera (110); and
determining in real-time, a position and an orientation of the optical marker device (104), using a computer vision technique; and
**characterised in that** the measurement data is generated using a digital caliper as the measurement device (102) and includes one or more of a length value, a breadth value, a height value and a radius value of the component.

## Patentansprüche

1. Verfahren, umfassend:
Erzeugen (502) von Messdaten einer Komponente unter Verwendung einer Messvorrichtung (102), die mit einer optischen Markervorrichtung (104) gekoppelt ist;
Erzeugen (504) von Koordinatendaten der Messvorrichtung (102) unter Verwendung der optischen Markervorrichtung (104) und mindestens einer Kamera (110);
Erzeugen (506) synchronisierter Messdaten durch Modifizieren der Messdaten basierend auf den Koordinatendaten;
Abrufen (508) zuvor gespeicherter Daten, die den synchronisierten Messdaten entsprechen, von einer Datenbank (120);
Erzeugen (510) von Rückkopplungsdaten basierend auf den zuvor gespeicherten Daten und den synchronisierten Messdaten unter Verwendung einer Augmented-Reality-Technik; und
Betreiben (512) der Messvorrichtung (102) basierend auf den Rückkopplungsdaten, um eine oder mehrere Messungen durchzuführen, die von der Komponente erfasst werden sollen;
wobei das Erzeugen der Koordinatendaten der Messvorrichtung (102) umfasst:
Erfassen eines oder mehrerer Bilder der optischen Markervorrichtung (104) unter Verwendung der mindestens einen Kamera (110);
und Bestimmen einer Position und einer Ausrichtung der optischen Markervorrichtung (104) in Echtzeit unter Verwendung einer Computervisionstechnik; und
**dadurch gekennzeichnet, dass** die Messdaten unter Verwendung eines digitalen Tasters als die Messvorrichtung (102) erzeugt werden und einen oder mehrere von einem Längenwert, einem Breitenwert, einem Höhenwert und einem Radiuswert der Komponente einschließen.

2. Verfahren nach Anspruch 1, ferner umfassend das Betreiben der Messvorrichtung (102) unter Verwendung einer Robotervorrichtung (148).

3. Verfahren nach Anspruch 1 oder 2, wobei das Erzeugen der Koordinatendaten ein Erhalten dreidimensionaler Koordinaten einer Vielzahl von optischen Markern der optischen Markervorrichtung (104) umfasst, die in einer zuvor definierten dreidimensionalen Konfiguration angeordnet sind.

4. Verfahren nach einem der vorstehenden Ansprüche, wobei die zuvor gespeicherten Daten zuvor definierte Messdaten und eine Vielzahl von Toleranzwerten umfassen, die den vordefinierten Messdaten entsprechen.

5. Verfahren nach einem der vorstehenden Ansprüche, wobei das Erzeugen der Rückkopplungsdaten ein Verifizieren einer Erfassung einer oder mehrerer Messungen der zuvor definierten Messdaten umfasst.

6. Verfahren nach einem der vorstehenden Ansprüche, wobei das Verifizieren der Erfassung der zuvor definierten Messdaten ein Identifizieren der einen oder der mehreren Messungen umfasst, die durch die Messvorrichtung erfasst werden sollen.

7. Verfahren nach einem der vorstehenden Ansprüche, wobei das Erzeugen der Rückkopplungsdaten das Erzeugen mindestens eines von grafischen und Audioinformationen umfasst, die für die Rückkopplungsdaten repräsentativ sind.

8. Verfahren nach einem der vorstehenden Ansprüche, wobei das Erzeugen der Rückkopplungsdaten ein Überlagern eines Live-Bildes eines Prüfbereichs der Komponente mit der einen oder den mehreren Messungen umfasst, die erfasst werden sollen.

9. System (100), umfassend:
eine Messvorrichtung (102), die mit einer optischen Markervorrichtung (104) des Systems gekoppelt werden soll und konfiguriert ist, um Messdaten einer Komponente zu erzeugen;
mindestens eine Kamera (110), die konfiguriert ist, um die optische Markervorrichtung (104) zu überwachen und Koordinatendaten der Messvorrichtung (102) zu erzeugen;
eine Messsteuereinheit (114), die mit der Messvorrichtung (102) und der mindestens einen Kamera (110) kommunikativ gekoppelt und konfiguriert ist zum:
Empfangen der Messdaten von der Messvorrichtung (102);
Empfangen der Koordinatendaten von der mindestens einen Kamera (110);
Modifizieren der Messdaten basierend auf den Koordinatendaten, um synchronisierte Messdaten zu erzeugen;
Abrufen zuvor gespeicherter Daten, die den synchronisierten Messdaten entsprechen, von einer Datenbank (120) des Systems;
Erzeugen von Rückkopplungsdaten basierend auf den zuvor gespeicherten Daten und den synchronisierten Messdaten unter Verwendung einer Augmented-Reality-Technik; und
Erzeugen eines Steuersignals (144) zum Betreiben der Messvorrichtung (102) basierend auf den Rückkopplungsdaten, um eine oder mehrere Messungen durchzuführen, die von der Komponente erfasst werden sollen;
wobei die mindestens eine Kamera (110) konfiguriert ist zum:
Erfassen eines oder mehrerer Bilder der optischen Markervorrichtung (104); und
Bestimmen einer Position und einer Ausrichtung der optischen Markervorrichtung (104) in Echtzeit unter Verwendung einer Computervisionstechnik; und
wobei die Messdaten einen oder mehrere von einem Längenwert, einem Breitenwert, einem Höhenwert und einem Radiuswert der Komponente einschließen;
**dadurch gekennzeichnet, dass** die Messvorrichtung (102) ein digitaler Taster ist.

10. System nach Anspruch 9, ferner umfassend eine Robotervorrichtung (148), die konfiguriert ist, um die Messvorrichtung (102) zu betreiben.

11. System nach Anspruch 9 oder 10, wobei die optische Markervorrichtung (104) eine Vielzahl von optischen Markern umfasst, die in einer zuvor definierten dreidimensionalen Konfiguration angeordnet sind.

12. Nichtflüchtiges computerlesbares Medium, das Anweisungen aufweist, um mindestens ein Prozessormodul zu aktivieren, um ein Verfahren durchzuführen, umfassend:
Erzeugen von Messdaten einer Komponente unter Verwendung einer Messvorrichtung (102), die mit einer optischen Markervorrichtung (104) gekoppelt ist;
Erzeugen von Koordinatendaten der Messvorrichtung (102) unter Verwendung der optischen Markervorrichtung (104) und mindestens einer Kamera (110);
Erzeugen synchronisierter Messdaten durch Modifizieren der Messdaten basierend auf den Koordinatendaten;
Abrufen zuvor gespeicherter Daten, die den synchronisierten Messdaten entsprechen, von einer Datenbank (120);
Erzeugen von Rückkopplungsdaten basierend auf den zuvor gespeicherten Daten und den synchronisierten Messdaten unter Verwendung einer Augmented-Reality-Technik; und
Erzeugen eines Steuersignals (144) zum Betreiben der Messvorrichtung (102) basierend auf den Rückkopplungsdaten, um eine oder mehrere Messungen durchzuführen, die von der Komponente erfasst werden sollen;
wobei das Erzeugen der Koordinatendaten der Messvorrichtung (102) umfasst:
Erfassen eines oder mehrerer Bilder der optischen Markervorrichtung (104) unter Verwendung der mindestens einen Kamera (110);
und Bestimmen einer Position und einer Ausrichtung der optischen Markervorrichtung (104) in Echtzeit unter Verwendung einer Computervisionstechnik; und
**dadurch gekennzeichnet, dass** die Messdaten unter Verwendung eines digitalen Tasters als die Messvorrichtung (102) erzeugt werden und einen oder mehrere von einem Längenwert, einem Breitenwert, einem Höhenwert und einem Radiuswert der Komponente einschließen.

## Revendications

1. Procédé comprenant :
la génération (502) de données de mesure d'un composant, à l'aide d'un dispositif de mesure (102) couplé à un dispositif de marqueur optique (104) ;
la génération (504) de données de coordonnées du dispositif de mesure (102), à l'aide du dispositif de marqueur optique (104) et au moins une caméra (110) ;
la génération (506) de données de mesure synchronisées par la modification des données de mesure en fonction des données de coordonnées ;
la récupération (508) de données pré-stockées correspondant aux données de mesure synchronisées, à partir d'une base de données (120) ;
la génération (510) de données de rétroaction en fonction des données pré-stockées et des données de mesure synchronisées, à l'aide d'une technique de réalité augmentée ; et
le fonctionnement (512) du dispositif de mesure (102) en fonction des données de rétroaction pour effectuer une ou plusieurs mesures à acquérir à partir du composant ;
dans lequel la génération des données de coordonnées du dispositif de mesure (102) comprend :
l'acquisition d'une ou plusieurs images du dispositif de marqueur optique (104) à l'aide de l'au moins une caméra (110) ;
et la détermination en temps réel, d'une position et d'une orientation du dispositif de marqueur optique (104), à l'aide d'une technique de vision par ordinateur ; et
**caractérisé en ce que** les données de mesure sont générées à l'aide d'un calibre numérique en guise de dispositif de mesure (102) et comportent une ou plusieurs d'une valeur de longueur, une valeur de largeur, une valeur de hauteur et une valeur de rayon du composant.

2. Procédé selon la revendication 1, comprenant en outre le fonctionnement du dispositif de mesure (102) à l'aide d'un dispositif de robot (148).

3. Procédé selon la revendication 1 ou la revendication 2, dans lequel la génération des données de coordonnées comprend l'obtention de coordonnées tridimensionnelles d'une pluralité de marqueurs optiques du dispositif de marqueur optique (104), agencés dans une configuration tridimensionnelle prédéfinie.

4. Procédé selon l'une quelconque revendication précédente, dans lequel les données pré-stockées comprennent des données de mesure prédéfinies et une pluralité de valeurs de tolérance correspondant aux données de mesure prédéfinies.

5. Procédé selon l'une quelconque revendication précédente, dans lequel la génération des données de rétroaction comprend la vérification d'acquisition d'une ou plusieurs mesures des données de mesure prédéfinies.

6. Procédé selon l'une quelconque revendication précédente, dans lequel la vérification d'acquisition des données de mesure prédéfinies comprend l'identification des une ou plusieurs mesures à acquérir par le dispositif de mesure.

7. Procédé selon l'une quelconque revendication précédente, dans lequel la génération des données de rétroaction comprend la génération d'au moins l'une parmi des informations graphiques et audio représentatives des données de rétroaction.

8. Procédé selon l'une quelconque revendication précédente, dans lequel la génération des données de rétroaction comprend la superposition d'une image en direct d'une région d'inspection du composant avec les une ou plusieurs mesures à acquérir.

9. Système (100) comprenant :
un dispositif de mesure (102) à coupler à un dispositif de marqueur optique (104) du système et configuré pour générer des données de mesure d'un composant ;
au moins une caméra (110) configurée pour surveiller le dispositif de marqueur optique (104) et générer des données de coordonnées du dispositif de mesure (102) ;
une unité de régulation de mesure (114) couplée en communication au dispositif de mesure (102) et à l'au moins une caméra (110) et configurée pour :
recevoir les données de mesure à partir du dispositif de mesure (102) ;
recevoir les données de coordonnées à partir de l'au moins une caméra (110) ;
modifier les données de mesure en fonction des données de coordonnées pour générer des données de mesure synchronisées ;
récupérer des données pré-stockées correspondant aux données de mesure synchronisées, à partir d'une base de données (120) du système ;
générer des données de rétroaction en fonction des données pré-stockées et des données de mesure synchronisées, à l'aide d'une technique de réalité augmentée ; et
générer un signal de régulation (144) pour le fonctionnement du dispositif de mesure (102) en fonction des données de rétroaction pour effectuer une ou plusieurs mesures à acquérir à partir du composant ;
dans lequel l'au moins une caméra (110) est configurée pour :
acquérir une ou plusieurs images du dispositif de marqueur optique (104) ; et
déterminer en temps réel, une position et une orientation du dispositif de marqueur optique (104), à l'aide d'une technique de vision par ordinateur ; et
dans lequel les données de mesure comportent une ou plusieurs d'une valeur de longueur, une valeur de largeur, une valeur de hauteur et une valeur de rayon du composant ;
**caractérisé en ce que** le dispositif de mesure (102) est un calibre numérique.

10. Système selon la revendication 9, comprenant en outre un dispositif de robot (148) configuré pour faire fonctionner le dispositif de mesure (102).

11. Système selon la revendication 9 ou la revendication 10, dans lequel le dispositif de marqueur optique (104) comprend une pluralité de marqueurs optiques agencés dans une configuration tridimensionnelle prédéfinie.

12. Support lisible par ordinateur non transitoire ayant des instructions pour permettre à au moins un module de processeur d'effectuer un procédé comprenant :
la génération de données de mesure d'un composant à l'aide d'un dispositif de mesure (102) couplé à un dispositif de marqueur optique (104) ;
la génération de données de coordonnées du dispositif de mesure (102), à l'aide du dispositif de marqueur optique (104) et au moins une caméra (110) ;
la génération de données de mesure synchronisées par la modification des données de mesure en fonction des données de coordonnées ;
la récupération de données pré-stockées correspondant aux données de mesure synchronisées, à partir d'une base de données (120) ;
la génération de données de rétroaction en fonction des données pré-stockées et des données de mesure synchronisées, à l'aide d'une technique de réalité augmentée ; et
la génération d'un signal de régulation (144) pour le fonctionnement du dispositif de mesure (102) en fonction des données de rétroaction pour effectuer une ou plusieurs mesures à acquérir à partir du composant ;
dans lequel la génération des données de coordonnées du dispositif de mesure (102) comprend :
l'acquisition d'une ou plusieurs images du dispositif de marqueur optique (104) à l'aide de l'au moins une caméra (110) ;
et la détermination en temps réel, d'une position et d'une orientation du dispositif de marqueur optique (104), à l'aide d'une technique de vision par ordinateur ; et
**caractérisé en ce que** les données de mesure sont générées à l'aide d'un calibre numérique en guise de dispositif de mesure (102) et comportent une ou plusieurs d'une valeur de longueur, une valeur de largeur, une valeur de hauteur et une valeur de rayon du composant.
